# EUROPÄISCHE PATENTANMELDUNG

(11) **EP 4 290 253 A2**
(43) Veröffentlichungstag der Anmeldung: **13.12.2023**
(21) Anmeldenummer: 23206020.2
(22) Anmeldetag: 21.04.2021
(51) Int. Cl.: G01R 31/28

(54) **TEMPERIERVORRICHTUNG, SYSTEM UND VERFAHREN ZUM TEMPERIEREN EINES PROBERTISCHES FÜR HALBLEITERWAFER UND/ODER HYBRIDE**

(30) Priorität: 18.05.2020 DE 102020002962
(62) Teilanmeldung aus: 21721042.6
(71) Anmelder: ATT Advanced Temperature Test Systems GmbH, 82152 Planegg (DE)
(72) Erfinder: EIBL, Markus, Planegg (DE); LIPPERT, Thomas, Planegg (DE); WIMMER, Ferdinand, Planegg (DE)
(74) Vertreter: Müller-Boré & Partner Patentanwälte PartG mbB

(57) **Zusammenfassung**

Eine Temperiervorrichtung (1) zum Temperieren eines Probertisches (110) für Halbleiterwafer und/oder Hybride weist einen Fluideingang (10) zum Einleiten eines Temperierfluids in die Temperiervorrichtung (1) auf und zumindest einen Wärmetauscher (20; 30) zum Temperieren des Temperierfluids. Ein Kühlbooster (70) ist zum Temperieren des Temperierfluids konfiguriert. Durch eine Probertemperierleitung (40) ist das temperierte Temperierfluid zum Probertisch (110) leitbar. Eine Eingangsfluidschaltung (80) ist dazu konfiguriert, das eingeleitete Temperierfluid auf ein Einführschaltsignal hin wahlweise entweder durch den zumindest einen Wärmetauscher (20; 30) oder durch den Kühlbooster (70) in die Probertemperierleitung (40) zu leiten.

## Beschreibung

Die Erfindung betrifft Temperiervorrichtungen, ein System mit einem Probertisch und einer Temperiervorrichtung sowie Verfahren zum Temperieren eines Probertisches für Halbleiterwafer und/oder Hybride.

Aus dem Stand der Technik sind Testvorrichtungen sowie Verfahren bekannt, bei denen Halbleiterwafer in Temperaturbereichen zwischen -200°C und +400°C getestet werden. Dabei wird ein Halbleiterwafer auf einen Probertisch gelegt, der auf die jeweils gewünschte Testtemperatur gekühlt und/oder beheizt wird. Solche Probertische werden auch Waferprober und/oder Chucks genannt. Zur Temperierung wird dabei ein Temperierfluid an und/oder durch den Probertisch geleitet, welches den Probertisch auf die gewünschte Testtemperatur abkühlt und/oder heizt. Grundsätzlich sind sowohl Verfahren mit flüssigen Temperierfluiden als auch mit gasförmigen Temperierfluiden bekannt.

Im Dokument EP 1 495 486 B3 wird eine Ausführungsform einer Temperiervorrichtung beschrieben, bei welcher ein Temperierfluid zunächst zum Temperieren eines Probertisches verwendet wird. Anschließend wird das Temperierfluid vom Probertisch zurück in die Temperiervorrichtung geleitet und dort durch einen Wärmetauscher, in welchem es zur Temperierung des frisch eingeleiteten Temperierfluids verwendet wird. Dies hat den Vorteil, dass das sozusagen recycelte, zurückgeführte Temperierfluid noch einmal verwendet werden kann zum Temperieren zumindest eines Teils des frisch in die Temperiervorrichtung eingeleiteten Temperierfluids. Dadurch kann die z.B. zum Herunterkühlen des Temperierfluids insgesamt benötigte Kühlenergie reduziert werden.

Die vorbekannten Verfahren und/oder Temperiervorrichtungen weisen den Nachteil auf, dass sie immer noch viel Energie zum Einstellen der Testtemperaturen des Probertisches benötigen.

Der Erfindung liegt die Aufgabe zugrunde, eine Möglichkeit bereitzustellen, Probertische auf eine energieeffiziente Art und Weise zu temperieren. Eine weitere Aufgabe der Erfindung kann es sein, eine Möglichkeit bereitzustellen, Testtemperaturen des Probertisches schneller einzustellen.

Diese Aufgabe wird durch die Gegenstände der unabhängigen Ansprüche gelöst. Bevorzugte Ausführungsformen sind die Gegenstände der abhängigen Ansprüche.

Ein erster Aspekt betrifft eine Temperiervorrichtung zum Temperieren eines Probertisches für Halbleiterwafer und/oder Hybride mit einem Fluideingang zum Einleiten eines Temperierfluids in die Temperiervorrichtung. Die Temperiervorrichtung weist einen ersten Wärmetauscher zum Vortemperieren des eingeleiteten Temperierfluids auf und einen zweiten Wärmetauscher zum Temperieren des Temperierfluids. Durch eine Probertemperierleitung ist das temperierte Temperierfluid zum Probertisch leitbar. Eine Rückführschaltung leitet ein vom Probertisch zurückgeführtes Temperierfluid auf ein Rückführschaltsignal hin wahlweise entweder durch den ersten Wärmetauscher oder lässt es unter Umgehung des ersten Wärmetauschers ausströmen.

Die Temperiervorrichtung kann als ein sogenannter Chiller ausgebildet sein, welcher dazu ausgebildet und vorgesehen ist, zumindest über die Probertemperierleitung an den Probertisch angeschlossen zu werden. So ein Probertisch zum Testen von Halbeiterwafern und/oder Hybriden wird auch als ein Chuck bezeichnet und ist üblicherweise in einem zumindest teilweise geschlossenen Proberbehälter angeordnet. Die Temperiervorrichtung kann somit als Teil eines Probersystems ausgebildet sein, welches sowohl die Temperiervorrichtung als auch den Probertisch mit oder ohne Proberbehälter aufweisen kann.

Die Temperiervorrichtung kann weiterhin eine Steuerung aufweisen und/oder mit einer Steuerung verbunden sein. Die Steuerung kann zumindest ein Schaltventil und/oder einen Prozessor aufweisen, auf welchem Softwareprogramme ausgeführt werden können.

Der Fluideingang dient zum Einleiten des Temperierfluids in die Temperiervorrichtung, z.B. in ein Gehäuse der Temperiervorrichtung, durch dessen Gehäusewandung der Fluideingang ausgebildet sein kann.

Als Temperierfluid kann ein flüssiges und/oder gasförmiges Fluid verwendet werden. Bevorzugt wird als Temperierfluid ein gasförmiges Fluid wie z.B. Trockenluft verwendet, wobei die Temperiervorrichtung als eine luftgekühlte Temperiervorrichtung ausgebildet ist.

Die Temperiervorrichtung weist zumindest zwei Wärmetauscher auf, nämlich den ersten Wärmetauscher zum Vortemperieren des eingeleiteten Temperierfluids und den zweiten Wärmetauscher zum eigentlichen Temperieren des Temperierfluids. Das Temperierfluid kann vom Fluideingang in den ersten Wärmetauscher geleitet sein und vom ersten Wärmetauscher zum zweiten Wärmetauscher. Vom zweiten Wärmetauscher kann es zu der Probertemperierleitung geleitet sein.

Das Temperieren des zugeführten Temperierfluids kann in mehreren Schritten und/oder Stufen erfolgen. So muss das Temperierfluid beim Vortemperieren im ersten Wärmetauscher noch nicht auf seine zum Temperieren gewünschte Zieltemperatur gebracht werden, also z.B. noch nicht auf die Testtemperatur des Probertisches. Beim Vortemperieren kann aber die Temperatur des zugeführten Temperierfluids von seiner Bereitstellungstemperatur, also z.B. von etwa Raumtemperatur, geändert werden hin zur gewünschten Zieltemperatur des Temperierfluid. Erst im zweiten Wärmetauscher wird das Temperierfluid auf seine gewünschte Zieltemperatur temperiert. Als Zieltemperatur des Temperierfluids kann z.B. die aktuell eingestellte Testtemperatur des Probertisches verwendet werden. Beim Abkühlen des Probertisches kann das Temperierfluid zumindest zeitweise auch auf eine möglichst minimale Zieltemperatur temperiert werden, welche deutlich kälter als die eigentliche Testtemperatur sein kann, um so den Probertisch möglichst schnell auf seine neue Testtemperatur zu regeln.

Der erste Wärmetauscher ist zum Vortemperieren des eingeleiteten, also zum Beispiel frischen Temperierfluids ausgebildet. Im ersten Wärmetauscher kann ein Wärmeaustausch zwischen dem frisch eingeleiteten Temperierfluid und dem zurückgeführten Temperierfluid stattfinden. Durch diesen Wärmeaustausch wird das frisch eingeleitete Temperierfluid vom zurückgeführten Temperierfluid, welches noch ungefähr in etwa die gewünschte Testtemperatur aufweisen kann, vortemperiert.

Die Rückführschaltung kann die Temperiervorrichtung in einen Rückführbetriebszustand schalten, in welchem das zurückgeführte und/oder zurückgeleitete Temperierfluid durch den ersten Wärmetauscher geleitet wird. Der Rückführbetriebszustand kann genutzt werden, um beispielsweise in einem Kühlbetrieb, in welchem der Probertisch auf eine niedrige Testtemperatur wie z.B. -40°C abgekühlt werden soll, im ersten Wärmetauscher das frisch eingeleitete Temperierfluid mittels des vom Probertisch zurückgeführten Temperierfluids vorzukühlen. So könnte das zurückgeführte Temperierfluid immerhin noch eine Kälte von zum Beispiel -30°C aufweisen, mit welcher das z.B. etwa unter Raumtemperatur eingeleitete frische Temperierfluid gut vorgekühlt werden kann. Unter dieser Nutzung der Kälte des zurückgeführten Temperierfluids könnte das frisch eingeleitete Temperierfluid immerhin schon um einige Grad, z.B. auf eine Temperatur unter 0°C, vorgekühlt werden. Anschließend kann das frische Temperierfluid im zweiten Wärmetauscher auf seine Zieltemperatur heruntergekühlt werden, z.B. auf die vorbestimmte Testtemperatur von z.B. -40°C.

Das Vortemperieren ermöglicht es einerseits, möglichst energiesparend die Zieltemperatur zu erreichen, indem der Wärme- und/oder Kälteinhalt des zurückgeführten Temperierfluids sinnvoll genutzt wird. Andererseits kann das Vortemperieren ein Erreichen extremer Temperaturen erst ermöglichen. So kann beispielsweise erst die Nutzung des zurückgeführten Temperierfluids zum Vortemperieren des frischen Temperierfluids ein Erreichen einer sehr kalten Temperatur ermöglichen.

Während die Nutzung des zurückgeführten Temperierfluids zum Vortemperieren des frischen Temperierfluids in einer Mehrzahl von Betriebszuständen der Temperiervorrichtung somit sinnvoll sein kann und zur Energieeffizienz beitragen kann, kann dies in anderen Betriebszuständen negative Auswirkungen auf die Energienutzung haben und dabei z.B. zu einem relativ hohen Energieverbrauch führen.

Wird z.B. der Probertisch von einer relativ hohen Testtemperatur (z.B. von mehreren hundert Grad Celsius) heruntergekühlt auf eine Temperatur nahe der Raumtemperatur, so ist ein Vortemperieren mit dem heißen zurückgeführten Temperaturfluid unerwünscht. Denn dann würde das Vortemperieren das z.B. bei etwa Raumtemperatur frisch hinzugeführte Temperaturfluid zunächst auf eine zu hohe Temperatur vorheizen, bevor es im zweiten Wärmetauscher wieder auf die Testtemperatur heruntergekühlt werden muss. Dazu werden eine hohe Kühlleistung und somit viel Kühlenergie benötigt.

Um die Energienutzung zu verbessern, weist die Temperiervorrichtung die Rückführschaltung auf. Die Rückführschaltung erhält zum Beispiel von der Steuerung das Rückführschaltsignal. Das Rückführschaltsignal kann abhängig vom jeweils gewünschten Betriebszustand und/oder Modus der Temperiervorrichtung sein.

Soll der Probertisch zum Beispiel eine starke Kühlleistung erbringen und ist nicht vorgeheizt, so kann die Rückführschaltung das zurückgeführte Temperierfluid durch den ersten Wärmetauscher leiten, wo es zum Vortemperieren des frisch eingeleiteten Temperierfluids verwendet werden kann. Die Rückführschaltung befindet sich dann im Rückführbetriebszustand.

Zum Abkühlen des Probertisches von einem stark aufgeheizten Zustand kann die Rückführschaltung auf ein entsprechendes Rückführschaltsignal hin das zurückgeführte Temperierfluid umleiten. In einem solchen Zustand kann die Rückführschaltung das zurückgeführte Fluid zum Beispiel ausströmen lassen. Jedenfalls leitet die Rückführschaltung das zurückgeführte Temperierfluid in diesem Zustand nicht mehr durch den ersten Wärmetauscher zum Vortemperieren des frischen Fluids. Die Rückführschaltung befindet sich dann im Ausström betriebszustand.

Die Rückführschaltung ist somit reversibel zwischen zumindest zwei Zuständen schaltbar, nämlich zwischen dem Rückführbetriebszustand und dem Ausströmbetriebszustand. Im Rückführbetriebszustand der Rückführschaltung wird das zurückgeführte Temperierfluid durch den ersten Wärmetauscher geleitet und im Ausströmbetriebszustand der Rückführschaltung wird das zurückgeführte Temperierfluid unter Umgehung des ersten Wärmetauschers ausströmen gelassen. Beispielsweise kann es dann einfach in die Umgebung ausgeströmt werden, ohne durch den ersten Wärmetauscher geleitet zu werden.

Durch die Rückführschaltung wird insbesondere beim starken Abkühlen des Probertisches Kühlenergie eingespart, da das zurückgeführte Temperierfluid das frische Temperierfluid nicht mehr im ersten Wärmetauscher unnötig aufheizt, wenn die vorbestimmte Testtemperatur dies nicht erfordert. Die Rückführschaltung kann somit Kühlenergie einsparen und dabei die Betriebskosten der Temperiervorrichtung senken. Weiterhin kann auch der von der Temperiervorrichtung verursachte Betriebslärm reduziert werden, indem zumindest in manchen Betriebszuständen im zweiten Wärmetauscher weniger stark gekühlt werden muss. Weiterhin können durch die Energieeinsparungen Betriebskosten eingespart werden, insbesondere Betriebskosten wie Strom und/oder durch Verschleiß bedingte Wartungskosten einer an den zweiten Wärmetauscher gekoppelten Kühlvorrichtung.

Das zurückgeführte Temperierfluid kann nach dem Vortemperieren im ersten Wärmetauscher entweder an die Umgebung ausströmen gelassen werden, und/oder im Proberbehälter ausströmen gelassen werden, um dort die Raumluft zu konditionieren. Gleiches gilt für das Ausströmen des zurückgeführten Temperierfluids unter Umgehung des ersten Wärmetauschers.

Die Möglichkeit, das zurückgeführte Temperierfluid unter Umgehung des ersten Wärmetauschers ausströmen zu lassen, erlaubt es in manchen Betriebszuständen und/oder Betriebsübergängen, die Testtemperatur am Probertisch deutlich schneller einzustellen als unter Nutzung des zurückgeführten Wärmeinhalts. Dies gilt insbesondere beim Abkühlen des Probertisches von einem aufgeheizten Zustand von z.B. mehreren hundert Grad Celsius auf eine moderate Temperatur um die Raumtemperatur und/oder im negativen Grad Celsiusbereich.

Gemäß einer Ausführungsform temperiert das zurückgeführte Temperierfluid in einem Rückführbetriebszustand der Temperiervorrichtung das eingeleitete Temperierfluid in dem ersten Wärmetauscher vor, wenn es von der Rückführschaltung durch den ersten Wärmetauscher geleitet wird. Der Rückführbetriebszustand der Temperiervorrichtung kann dabei ein Betriebszustand sein, in dem sich die Temperatur in vergleichsweise kleinen Schritten ändert, zum Beispiel in Schritten von maximal 40K, bevorzugt von maximal 25K, besonders bevorzugt von maximal 10K. Allgemein kann der Kühlbetriebszustand der Temperiervorrichtung ein Zustand sein, in dem das frisch eingeleitete Temperierfluid sowohl im ersten Wärmetauscher vortemperiert wird als auch im zweiten Wärmetauscher auf seine Testtemperatur temperiert wird. Die Testtemperatur kann dabei z.B. in einem Bereich von einem einer minimal regelbaren Temperatur der Temperiervorrichtung bis zu einer unteren Grenzwerttemperatur liegen. Die minimal regelbare Testtemperatur kann dabei die kleinste von der Temperiervorrichtung erreichbare Testtemperatur sein, zum Beispiel -40°C oder -55°C oder -200°C. Die untere Grenztemperatur kann in der Nähe der Raumtemperatur liegen, also zum Beispiel in einem Bereich von etwa 10°C bis etwa 35°C. In diesem Temperaturbereich von der minimal erreichbaren Testtemperatur bis zur unteren Grenztemperatur kann die Temperiervorrichtung üblicherweise im Rückführbetriebszustand betrieben werden.

Gemäß einer Ausführungsform wird das zurückgeführte Temperierfluid nach Durchströmen des ersten Wärmetauschers über einen Ausströmausgang ausströmen gelassen. Hierbei kann eine Ausströmleitung vorgesehen sein, die den ersten Wärmetauscher mit dem Ausströmausgang verbindet. Über den Ausströmausgang kann das zurückgeführte Temperierfluid beispielsweise in die Umgebung ausströmen gelassen werden und/oder zumindest teilweise zur Konditionierung des Proberbehälters verwendet werden.

Gemäß einer Ausführungsform lässt die Rückführschaltung in einem Ausströmbetriebszustand der Temperiervorrichtung das vom Probertisch zurückgeführte Temperierfluid unter Umgehung des ersten Wärmetauschers ausströmen, wenn der Probertisch von einem aufgeheizten Zustand abgekühlt wird. Im Ausströmbetriebszustand wird somit das zurückgeführte Temperierfluid nicht mehr zum Vortemperieren des eingeleiteten frischen Temperierfluids verwendet. Dadurch kann die im Ausströmbetriebszustand am zweiten Wärmetauscher benötigte Kühlenergie reduziert werden.

Allgemein kann das zurückgeführte Temperierfluid unter Umgehung des ersten Wärmetauschers ausströmen gelassen werden, wenn ein Vortemperieren kontraproduktiv zum Temperieren ist, also z.B. die Temperatur des zurückgeführten Temperierfluids zu stark abweicht von der Zieltemperatur, auf die das eingeleitete Temperierfluid temperiert werden soll.

Weiterhin besteht auch die Möglichkeit, das zurückgeführte Temperierfluid genau dann unter Umgehung des ersten Wärmetauschers ausströmen zu lassen, wenn die zu erreichende Zieltemperatur näher an der Bereitstellungs- oder Einleitungstemperatur (also z.B. etwa Raumtemperatur) des frisch eingeleiteten Temperierfluids ist als an der Rückführtemperatur des zurückgeführten Temperierfluids. Hierbei kann es sich von der aufzuwendenden Kühlleistung betrachtet nahezu immer lohnen, auf die Vortemperierung im ersten Wärmetauscher zu verzichten.

Gemäß einer Ausführungsform lässt die Rückführschaltung in einem Ausströmbetriebszustand der Temperiervorrichtung das vom Probertisch zurückgeführte Temperierfluid unter Umgehung des ersten Wärmetauschers ausströmen, wenn der Probertisch von einer ersten Temperatur abgekühlt wird auf eine zweite Temperatur, die um mehr als etwa 50K kleiner als die erste Temperatur ist. Die Temperiervorrichtung wird in den Ausströmbetriebszustand gebracht, wenn die zweite Temperatur als Testtemperatur des frischen Temperierfluids um mehr als etwa 50K, also zum Beispiel um zumindest etwa 100K oder etwa 200K, von der ersten Temperatur, also der aktuellen IST-Temperatur des Probertisches, abweicht. Auch dies kann im zweiten Wärmetauscher aufzubringende Kühlleistung einsparen.

Gemäß einer Ausführungsform lässt die Rückführschaltung beim Abkühlen des Probertisches in einem Ausströmbetriebszustand der Temperiervorrichtung das vom Probertisch zurückgeführte Temperierfluid solange unter Umgehung des ersten Wärmetauschers ausströmen, bis eine Temperatur des Probertisches unter eine Probertischgrenztemperatur aus einem Bereich von etwa 20°C bis etwa 40°C fällt. Bevorzugt ist die Probertischgrenztemperatur etwas größer als die Raumtemperatur und/oder Bereitstellungstemperatur des Temperierfluids und beträgt z.B. etwa 30°C. Fällt die Temperatur des Probertisches unter die Probertischgrenztemperatur, so kann die Temperiervorrichtung in den Rückführbetriebszustand geschalten werden.

Gemäß einer Ausführungsform leitet die Rückführschaltung in einem Rückführbetriebszustand der Temperiervorrichtung das vom Probertisch zurückgeführte Temperierfluid durch den ersten Wärmetauscher, wenn der Probertisch auf eine Temperatur unterhalb einer Rückführgrenztemperatur temperiert wird. Hierbei kann die Rückführgrenztemperatur in einem Bereich von etwa 10°C bis etwa 40°C liegen, insbesondere im Bereich von etwa 20°C bis etwa 35°C. Bei einer solchen Testtemperatur kann es meistens sinnvoll sein, die Temperiervorrichtung im Rückführbetriebszustand zu betreiben, um so die relative Kälte des zurückgeführten Temperierfluids zum Vortemperieren des frisch eingeleiteten Temperierfluids zu nutzen.

Allgemein kann die Rückführschaltung neben einer Leitungsgabelung ein Ablassventil und/oder ein Überdruckventil und/oder ein Schaltventil aufweisen, durch dessen (bzw. deren) Schaltstellung(en) einstellbar ist, ob das zurückgeführte Temperierfluid ausströmen gelassen wird oder ob es durch den ersten Wärmetauscher geleitet wird.

Ein zweiter Aspekt betrifft eine Temperiervorrichtung zum Temperieren eines Probertisches für Halbleiterwafer und/oder Hybride. Dabei kann es sich insbesondere um eine Temperiervorrichtung gemäß dem ersten Aspekt handeln. Die Temperiervorrichtung weist einen Fluideingang zum Einleiten eines Temperierfluids in die Temperiervorrichtung auf und zumindest einen Wärmetauscher zum Temperieren des Temperierfluids. Ein Kühlbooster ist ebenfalls vorgesehen zum Temperieren des Temperierfluids. Die Temperiervorrichtung weist eine Probertemperierleitung auf, durch welche das temperierte Temperierfluid zum Probertisch leitbar ist. Eine Eingangsfluidschaltung leitet das eingeleitete Temperierfluid auf ein Einführschaltsignal hin wahlweise entweder durch den zumindest einen Wärmetauscher oder durch den Kühlbooster in die Probertem perierleitung.

Die Temperiervorrichtung kann insbesondere als eine Temperiervorrichtung gemäß dem ersten Aspekt ausgebildet sein. Deswegen können die Ausführungen zu einzelnen Merkmalen der Temperiervorrichtung gemäß dem ersten Aspekt auch die Temperiervorrichtung gemäß dem zweiten Aspekt betreffen und umgekehrt. So können sich insbesondere der Fluideingang, das Temperierfluid, die Probertemperierleitung usw. ähneln oder gleichen. Der zumindest eine Wärmetauscher der Temperiervorrichtung gemäß dem zweiten Aspekt kann z.B. der zweite oder erste Wärmetauscher der vorangehend beschriebenen Temperiervorrichtung gemäß dem ersten Aspekt sein.

Die Temperiervorrichtung gemäß dem zweiten Aspekt weist im Unterschied und/oder zusätzlich zu den Elementen der Temperiervorrichtung gemäß dem ersten Aspekt zumindest den Kühlbooster und die Eingangsfluidschaltung auf. Die Eingangsfluidschaltung erhält z.B. von einer Steuerung das Einführschaltsignal, mit welchem die Eingangsfluidschaltung gesteuert und/oder geregelt wird, so dass zumindest ein Großteil des eingeleiteten Temperierfluids entweder durch den zumindest einen Wärmetauscher oder durch den Kühlbooster geleitet wird.

Abhängig vom gewählten und/oder geschalteten Leitungspfad des eingeleiteten Temperierfluids ergeben sich unterschiedliche Betriebsmodi der Temperiervorrichtung. Im Wärmetauschermodus wird das eingeleitete Temperierfluid durch den zumindest einen Wärmetauscher geleitet. Im Boostermodus wird das eingeleitete Temperierfluid stattdessen im Kühlbooster temperiert. Abhängig von der gewünschten Testtemperatur des Probertisches kann einer der beiden Modi energetisch günstiger sein.

So kann es in einem Tieftemperaturbereich notwendig sein, das eingeleitete Temperierfluid in dem zumindest einen Wärmetauscher zu temperieren, da nur so die tiefe Testtemperatur erreicht werden kann. Allerdings kann es in einem moderaten Temperaturbereich sinnvoll sein, den Wärmetauscher mit zugehöriger Kühlvorrichtung abzuschalten und stattdessen die Testtemperatur nur mit dem Kühlbooster einzustellen, welcher im Betrieb weniger Leistung benötigt. Der Boostermodus kann so z.B. bei niedrigen positiven Temperaturen rund um die Raumtemperatur sinnvoll sein. So kann der Kühlbooster signifikant weniger Betriebsenergie benötigen als eine Kühlvorrichtung für den zweiten Wärmetauscher, da diese Kühlvorrichtung ein Kühlaggregat und/oder einen Kompressor benötigen kann.

Die Temperiervorrichtung kombiniert die Vorteile der Nutzung eines Kühlboosters, welcher vergleichsweise wenig Betriebsenergie benötigt, mit der Möglichkeit, das Temperierfluid im (z.B. zweiten) Wärmetauscher auf eine sehr niedrige Temperatur herunterkühlen zu können, welche vom Kühlbooster allein nicht erreicht werden kann. Dabei kann die Eingangsfluidschaltung möglichst intelligent angesteuert werden, um so einen möglichst energiesparenden Betrieb zu ermöglichen.

Hierbei kann eine Verzweigung und/oder eine Zusammenführung vorgesehen sein, an der eine Ausgangsleitung aus dem zumindest einen Wärmetauscher an eine Ausgangsleitung aus dem Kühlbooster derart gekoppelt ist, dass das temperierte Temperierfluid entweder aus dem Wärmetauscher oder aus dem Kühlbooster in die Probertemperierleitung eingeleitet werden kann. Dazu kann beispielsweise ein Wechselventil und/oder ein Oderventil verwendet werden.

Gemäß einer Ausführungsform leitet die Eingangsfluidschaltung in einem Wärmetauschermodus der Temperiervorrichtung das eingeleitete Temperierfluid durch den zumindest einen Wärmetauscher in die Probertemperierleitung, wenn der Probertisch von einem aufgeheizten Zustand abgekühlt wird. Hierbei ist der Wärmetauschermodus derjenige Betriebsmodus der Temperiervorrichtung, in welchem die Eingangsfluidschaltung das frisch eingeleitete Temperierfluid durch den zumindest einen Wärmetauscher leitet. Dies kann beispielsweise in einem im Zusammenhang mit dem ersten Aspekt beschriebenen Ausströmbetriebszustand vorteilhaft sein, in welchem der Probertisch schnell von einem aufgeheizten Zustand abgekühlt werden soll.

Gemäß einer Ausführungsform leitet die Eingangsfluidschaltung in einem Wärmetauschermodus der Temperiervorrichtung das eingeleitete Temperierfluid durch den zumindest einen Wärmetauscher in die Probertemperierleitung, wenn der Probertisch auf eine Temperatur unterhalb einer unteren Grenztemperatur, welche im Bereich von etwa 10°C bis etwa 25°C liegen kann, temperiert wird. Hierbei ist die Temperiervorrichtung derart konfiguriert, dass sie immer dann, wenn der Probertisch auf eine Zieltemperatur unterhalb der unteren Grenztemperatur temperiert werden soll, immer im Wärmetauschermodus betrieben werden kann.

Gemäß einer Ausführungsform leitet die Eingangsfluidschaltung in einem Boostermodus der Temperiervorrichtung das eingeleitete Temperierfluid durch den Kühlbooster in die Probertemperierleitung, wenn der Probertisch auf eine Temperatur oberhalb einer unteren Grenztemperatur, welche im Bereich von etwa 10°C bis etwa 25°C liegt, und unterhalb einer oberen Grenztemperatur, welche im Bereich von etwa 40°C bis etwa 70°C liegt, temperiert wird. Im Boostermodus benötigt die Temperiervorrichtung normalerweise weniger Betriebsenergie als im Wärmetauschermodus. Deshalb ist es energetisch sinnvoll, den Betrieb der Temperiervorrichtung im Boostermodus zu ermöglichen. Im Boostermodus kann eine Kühlvorrichtung zum Herunterkühlen des zumindest einen Wärmetauschers abgeschaltet werden, was das Betriebsgeräusch der Temperiervorrichtung reduzieren kann. Der Boostermodus eignet sich insbesondere für einen Betrieb der Temperiervorrichtung, bei der der Probertisch auf eine Testtemperatur in einem moderaten Temperaturbereich, z.B. um die Raumtemperatur herum, temperiert werden soll. Dabei kann der moderate Temperaturbereich etwa von der unteren Grenztemperatur bis etwa zur oberen Grenztemperatur reichen. In einem Ausführungsbeispiel kann die untere Grenztemperatur bei etwa 15°C liegen. In einem Ausführungsbeispiel kann die obere Grenztemperatur bei etwa 50°C oder etwa 60°C liegen.

Gemäß einer Ausführungsform weist der Kühlbooster ein Wirbelrohr auf, in dem das eingeleitete Temperierfluid in einen warmen und einen kalten Stromanteil aufgeteilt wird, von welchem nur der kalte Stromanteil in die Probertemperierleitung geleitet wird. Das Prinzip des Wirbelrohrs ist dem Fachmann bekannt. Im Wirbelrohr wird das eingeleitete Temperierfluid so verwirbelt und/oder in Rotation versetzt, dass es in einen warmen und kalten Anteil aufgeteilt wird. Der warme und kalte Anteil des Temperierfluids werden durch unterschiedliche Ausgänge aus dem Wirbelrohr und/oder dem Kühlbooster herausgeleitet. Dabei wird lediglich der kalte Anteil des Temperierfluids weiterverwendet und zum Temperieren des Probertisches vorgesehen. Dieser kalte Anteil wird in die Probertemperierleitung geleitet.

Gemäß einer Ausführungsform weist die Eingangsfluidschaltung ein Schaltventil auf, durch welches das eingeleitete Temperierfluid in Abhängigkeit von der Schaltstellung des Schaltventils wahlweise entweder zu dem zumindest einen Wärmetauscher oder zu dem Kühlbooster geleitet wird. Das Schaltventil ist hierbei so in einer Leitung für das eingeleitete Temperierfluid angeordnet, dass dessen Stellung das Temperierfluid entweder in Richtung zu dem zumindest einen Wärmetauscher hin oder zum Kühlbooster hin leitet. Hierbei muss das Schaltventil nicht unmittelbar mit dem Kühlbooster und/oder dem Wärmetauscher verbunden sein. Beispielsweise kann es vor dem zumindest einen Wärmetauscher zum Temperieren in einen anderen (z.B. ersten) Wärmetauscher zum Vortemperieren eingeleitet werden. Außerdem kann zwischen dem Schaltventil und dem Kühlbooster zumindest ein weiteres Ventil und/oder eine Schaltung und/oder ein anderer (z.B. erster) Wärmetauscher vorgesehen sein.

Ein dritter Aspekt betrifft ein System mit einem Probertisch und einer daran zumindest über seine Probertemperierleitung angeschlossene Temperiervorrichtung nach dem ersten und/oder zweiten Aspekt. Das System kann als ein Probersystem ausgebildet sein und den Probertisch in einem zumindest teilweise geschlossenen Proberbehälter aufweisen. Im Proberbehälter können Reinraumverhältnisse vorliegen. Das System kann dazu verwendet werden, Halbleiterwafer und/oder Hybride zu testen unter kontrolliert einstellbaren Bedingungen wie zum Beispiel vorgebbaren Testtemperaturen. Alternativ kann das System auch ohne den Proberbehälter ausgebildet sein und die Temperiervorrichtung, den Probertisch und gegebenenfalls benötigte Leitungen aufweisen.

Ein vierter Aspekt betrifft ein Verfahren zum Temperieren eines Probertisches für Halbleiterwafer und/oder Hybride mit den Schritten:
- Einleiten eines Temperierfluids in einen ersten Wärmetauscher zum Vortemperieren des eingeleiteten Temperierfluids;
- Leiten des Temperierfluids vom ersten Wärmetauscher in einen zweiten Wärmetauscher zum Temperieren des Temperierfluids;
- Leiten des temperierten Temperierfluids zum Probertisch; und
- Bereitstellen eines Rückführschaltsignals zum Ansteuern und/oder Regeln einer Rückführschaltung, wobei ein vom Probertisch zurückgeführtes Temperierfluid auf das Rückführschaltsignal hin wahlweise entweder durch den ersten Wärmetauscher geleitet wird oder unter Umgehung des ersten Wärmetauschers ausströmen gelassen wird.

Das Verfahren kann insbesondere unter Nutzung einer Temperiervorrichtung gemäß dem ersten Aspekt durchgeführt werden. Deswegen betreffen sämtliche Ausführungen zur Temperiervorrichtung gemäß dem ersten Aspekt auch das Verfahren gemäß dem vierten Aspekt und umgekehrt. Bei dem Verfahren kann das frisch eingeleitete Temperierfluid im ersten Wärmetauscher vortemperiert werden und im zweiten Wärmetauscher zum Beispiel auf seine Zieltemperatur temperiert werden. Die Rückführschaltung ermöglicht es, das zurückgeführte Temperierfluid genau dann im ersten Wärmetauscher zum Vortemperieren zu nutzen, wenn dies z.B. energetisch sinnvoll ist und in eine im zweiten Wärmetauscher benötigte Kälteleistung reduziert. In allen anderen Betriebszuständen kann das zurückgeführte Temperierfluid unter Umgehung des ersten Wärmetauschers ausströmen gelassen werden.

In einer Weiterbildung des Verfahrens wird zumindest einer der folgenden Schritte ausgeführt:
- Ausströmen lassen des vom Probertisch zurückgeführten Temperierfluids unter Umgehung des ersten Wärmetauschers, wenn der Probertisch von einem aufgeheizten Zustand abgekühlt wird; und/oder
- Leiten des vom Probertisch zurückgeführten Temperierfluids durch den ersten Wärmetauscher, wenn der Probertisch auf eine Temperatur unterhalb einer Rückführgrenztemperatur temperiert wird.

Das zurückgeführte Temperierfluid kann unter Umgehung des ersten Wärmetauschers ausströmen gelassen werden, wenn ein Ausströmbetriebszustand gewünscht ist, also zum Beispiel der Probertisch von einer ersten Temperatur abgekühlt wird auf eine zweite Temperatur, welche beispielsweise um zumindest etwa 50K kleiner als die erste Temperatur sein kann. Die Rückführgrenztemperatur unterhalb welcher das zurückgeführte Temperierfluid durch den ersten Wärmetauscher geleitet wird, kann in einem Bereich von etwa 20°C bis etwa 35°C liegen, insbesondere bei etwa 30°C und/oder bei Raumtemperatur.

Ein fünfter Aspekt betrifft ein Verfahren zum Temperieren eines Probertisches für Halbleiterwafer und/oder Hybride, welches insbesondere eine Ergänzung des voranstehend beschriebenen Verfahrens gemäß dem vierten Aspekt sein kann, mit den Schritten:
- Einleiten eines Temperierfluids in zumindest einen Wärmetauscher zum Temperieren des Temperierfluids;
- Einleiten des Temperierfluids in einen Kühlbooster zum Temperieren des Temperierfluids;
- Leiten des temperierten Temperierfluids zum Probertisch; und
- Bereitstellen eines Einführschaltsignals zum Ansteuern und/oder Regeln einer Eingangsfluidschaltung, wobei das eingeleitete Temperierfluid auf das Einführschaltsignal hin wahlweise entweder durch den zumindest einen Wärmetauscher oder durch den Kühlbooster zum Probertisch geleitet wird.

Das Verfahren kann insbesondere mittels der Temperiervorrichtung gemäß dem zweiten Aspekt durchgeführt werden. Deswegen betreffen sämtliche Ausführungen zur Temperiervorrichtung gemäß dem zweiten Aspekt auch das Verfahren gemäß dem fünften Aspekt und umgekehrt. Die Verfahrensschritte müssen nicht notwendigerweise in der aufgelisteten Reihenfolge durchgeführt werden. So kann das eingeleitete Temperierfluid abhängig vom Betriebsmodus entweder durch den zumindest einen Wärmetauscher oder durch den Kühlbooster geleitet werden, um das Temperierfluid zu temperieren. Während eines Testzyklus kann der Wärmetauschermodus und der Boostermodus unterschiedlich oft verwendet werden.

Gemäß einer Ausführungsform wird beim Verfahren zumindest einer der folgenden Schritte durchgeführt:
- Leiten des eingeleiteten Temperierfluids durch den zumindest einen Wärmetauscher zum Probertisch, wenn der Probertisch auf eine Temperatur unterhalb einer unteren Grenztemperatur, welche im Bereich von etwa 10°C bis etwa 25°C liegen kann, temperiert wird;
- Leiten des eingeleiteten Temperierfluids durch den Kühlbooster zum Probertisch, wenn der Probertisch auf eine Temperatur oberhalb einer unteren Grenztemperatur, welche im Bereich von etwa 10°C bis etwa 25°C liegen kann, und unterhalb der oberen Grenztemperatur, welche im Bereich von etwa 40°C bis etwa 70°C liegen kann, temperiert wird;
- Abschalten einer im Wärmetauscher zur Temperierung genutzten Kühlvorrichtung, wenn das eingeleitete Temperierfluid durch den Kühlbooster zum Probertisch geleitet wird; und/oder
- Abschalten einer im Wärmetauscher zur Temperierung genutzten Kühlvorrichtung und/oder des Kühlboosters, wenn der Probertisch auf eine Temperatur oberhalb der oberen Grenztemperatur, welche im Bereich von etwa 40°C bis etwa 70°C liegen kann, temperiert wird.

In einem Wärmetauschermodus kann das eingeleitete Temperierfluid durch den Wärmetauscher zum Probertisch geleitet werden, wobei es auch im Wärmetauscher temperiert wird. In einem Boostermodus wird das Temperierfluid durch den Kühlbooster geleitet und dort temperiert, bevor es zum Probertisch geleitet wird. Der Wärmetauschermodus kann beispielsweise immer dann benutzt werden, wenn der Probertisch auf eine Temperatur unterhalb der unteren Grenztemperatur temperiert werden soll. Der Boostermodus kann in einem moderaten Temperaturbereich verwendet werden, welcher Zieltemperaturen von der unteren Grenztemperatur bis zur oberen Grenztemperatur umfassen kann.

Soll der Probertisch auf eine Testtemperatur oberhalb der oberen Grenztemperatur temperiert werden, so kann zumindest der Wärmetauscher und/oder der Kühlbooster abgeschaltet oder in Standby versetzt werden, da solche Testtemperaturen durch eine Heizung am Probertisch eingestellt werden können. Dies bedeutet, dass das Probersystem und/oder die Temperiervorrichtung dann in einem Heizbetriebszustand betrieben werden kann. In diesem Heizbetriebszustand kann durch Abschalten und/oder Herunterfahren einer zur Temperierung im Wärmetauscher genutzten Kühlvorrichtung und/oder des Kühlboosters Energie und Kosten eingespart werden. Auch wenn das eingeleitete Temperierfluid im Kühlbooster temperiert wird, also die Temperiervorrichtung im Boostermodus betrieben wird, kann der zumindest eine Wärmetauscher abgeschaltet und/oder in Standby versetzt werden, um so die insgesamt benötigte Energie zu reduzieren.

Im Rahmen dieser Erfindung können die Begriffe "im Wesentlichen" und/oder "etwa" so verwendet sein, dass sie eine Abweichung von bis zu 5% von einem auf den Begriff folgenden Zahlenwert beinhalten, eine Abweichung von bis zu 5° von einer auf den Begriff folgenden Richtung und/oder von einem auf den Begriff folgenden Winkel.

Der Begriff "Testtemperatur" kann eine Temperatur bezeichnen, welche der Probertisch aufweisen soll, um den Halbleiterwafer zu testen. Während eines Testzyklus kann der Probertisch hintereinander auf unterschiedliche Testtemperaturen geregelt werden, um so den auf dem Probertisch angeordneten Halbleiterwafer bei unterschiedlichen Testtemperaturen zu prüfen.

Der Begriff "Zieltemperatur" kann eine Temperatur bezeichnen, auf welche das Temperierfluid in der Temperiervorrichtung temperiert und/oder eingestellt werden soll, um den Probertisch auf seine Testtemperatur zu bringen. Die Temperierung des Temperierfluids kann z.B. im zweiten Wärmetauscher oder im Kühlbooster der Temperiervorrichtung erfolgen. Die Zieltemperatur kann von der Testtemperatur abweichen oder ihr gleich sein.

Die Erfindung wird nachfolgend anhand von in Figuren gezeigten Ausführungsbeispielen näher beschrieben. Hierbei können gleiche oder ähnliche Bezugszeichen gleiche oder ähnliche Merkmale der Ausführungsformen kennzeichnen. Einzelne in den Figuren gezeigte Merkmale können in anderen Ausführungsbeispielen implementiert sein. Es zeigen:
- Figur 1: eine schematische Skizze eines Probersystems mit einer Temperiervorrichtung mit einer Rückführschaltung;
- Figur 2: eine schematische Skizze eines Probersystems mit einer Temperiervorrichtung mit einer Eingangsfluidschaltung;
- Figur 3: eine schematische Skizze eines Probersystems mit einer Temperiervorrichtung mit einer Rückführschaltung und mit einer Eingangsfluidschaltung; und
- Figur 4: einen schematischen Schaltplan eines Probersystems mit Rückführschaltung und mit Eingangsfluidschaltung.

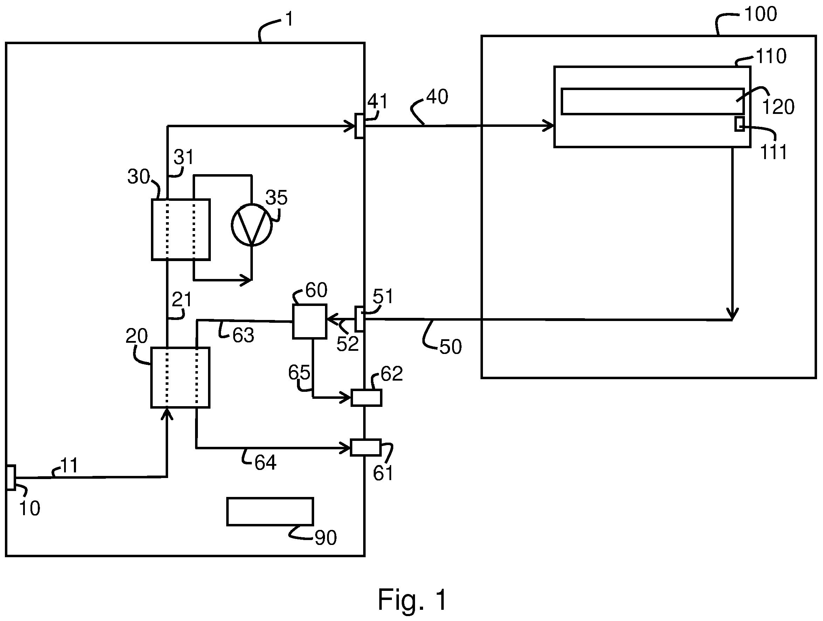

**Figur 1** zeigt eine schematische Skizze eines Probersystems mit einer Temperiervorrichtung 1 und einem Proberbehälter 100. Der Proberbehälter 100 kann als ein im Wesentlichen geschlossener Raum ausgebildet sein, in welchem ein Probertisch 110 angeordnet ist. Der Probertisch 110 wird auch als Chuck bezeichnet. Zur Temperaturüberwachung kann im Probertisch 110 ein Temperatursensor 111 angeordnet sein. Weiterhin kann im Probertisch 110 eine Heizung 120 angeordnet sein, um den Probertisch 110 auf Testtemperaturen oberhalb der Raumtemperatur zu konditionieren, zum Beispiel auf Testtemperaturen im positiven, dreistelligen Grad Celsius Bereich.

Die Temperiervorrichtung 1 kann als ein vom Proberbehälter 100 separates Bauteil ausgebildet sein und zum Beispiel ein Gehäuse aufweisen, in dem mehrere Bauelemente angeordnet sind. Die Temperiervorrichtung 1 wird auch als ein Chiller bezeichnet. Ein Probersystem mit Temperiervorrichtung 1 und Probertisch 110 wird auch als ein Chucksystem bezeichnet.

Die Temperiervorrichtung 1 kann eine Steuerung 90 aufweisen, welche wie gezeigt integriert im Gehäuse der Temperiervorrichtung 1 angeordnet sein kann. Alternativ kann die Steuerung 90 als ein separates Bauteil vorgesehen sein kann, welches mit der Temperiervorrichtung 1 z.B. elektrisch und/oder über Fluidleitungen verbunden werden kann. Die Steuerung 90 kann weiterhin elektrisch mit den Elementen des Probersystems verbunden sein, insbesondere mit dem Temperatursensor 111, der Heizung 120, einer Rückführschaltung 60, Ventilen, und/oder einer Kühlvorrichtung 35.

Die Temperiervorrichtung 1 weist einen Fluideingang 10 auf für frisch eingeleitetes Temperierfluid. Der Fluideingang 10 kann zum Beispiel mit Trockenluft versorgt werden, welche in etwa bei Raumtemperatur in die Temperiervorrichtung 1 eingeleitet werden kann. Prinzipiell kann auch ein anderes Temperierfluid als Luft verwendet werden, beispielsweise ein anderes Gasgemisch und/oder ein flüssiges Fluid. Bevorzugt ist die Temperiervorrichtung 1 jedoch als eine Luftkühlvorrichtung ausgebildet, welche die Temperierung des Probertisches 110 mit einem möglichst trockenen Luftgemisch durchführt.

Die Temperiervorrichtung 1 weist ferner einen ersten Wärmetauscher 20 und einen zweiten Wärmetauscher 30 auf. Das über den Fluideingang 10 frisch eingeleitete Temperierfluid kann über eine Eingangsleitung 11 zunächst durch den ersten Wärmetauscher 20 geleitet werden, in welchem es vortemperiert werden kann. Von dort kann es durch eine Wärmetauscherverbindungsleitung 21 zum und durch den zweiten Wärmetauscher 30, und von dort durch eine Wärmetauscherausgangsleitung 31 zu einem Fluidausgang 41 geleitet werden. Vor dem Fluidausgang 41, z.B. in der Wärmetauscherausgangsleitung 31, kann ein Fluidtemperatursensor angeordnet sein, welcher die Temperatur des temperierten Temperierfluids überprüft und welcher mit der Steuerung 90 verbunden ist und/oder kommuniziert. Der Fluidtemperatursensor kann zur erweiterten Überwachung und/oder Steuerung und/oder Regelung der verschiedenen Betriebszustände der Kühlvorrichtung 35, der Temperiervorrichtung 1 und/oder des Probersystems verwendet werden. Alternativ dazu kann der Fluidtemperatursensor auch hinter dem Fluidausgang in der Probertemperierleitung 40 angeordnet sein.

Beim Durchlaufen des ersten Wärmetauschers 20 kann das frisch eingeleitete Temperierfluid vortemperiert werden. Abhängig vom Betriebszustand der Temperiervorrichtung 1 kann das frisch eingeleitete Temperierfluid den ersten Wärmetauscher 20 auch ohne Vortemperierung durchlaufen, d.h. mit nahezu unveränderter Temperatur.

Der zweite Wärmetauscher 30 dient zum Einstellen der gewünschten Zieltemperatur des Temperierfluids. Im zweiten Wärmetauscher 30 erfolgt ein Wärmeaustausch mit einem Kühlfluid, welches in der Kühlvorrichtung 35 gekühlt wird. Die Kühlvorrichtung 35 kann ein oder mehrere Kühlaggregate, Kompressoren und/oder ähnliche Kühlvorrichtungen aufweisen, um das Kühlfluid abzukühlen. Die Kühlvorrichtung 35 leistet einen Großteil der zu verrichtenden Kühlleistung und kann weiterhin für einen Großteil des Betriebsgeräusches verantwortlich sein. Aus diesem Grund nutzt die Temperiervorrichtung 1 die Kühlvorrichtung 35 möglichst nur dann, wenn dessen Kühlleistung unbedingt erforderlich ist. In allen anderen Betriebszuständen der Temperiervorrichtung 1 wird die Kühlvorrichtung 35 entweder möglichst ausgeschaltet oder in Standby versetzt, um so sowohl Energie einzusparen als auch Betriebsgeräusche zu reduzieren.

Vom Fluidausgang 41 wird das auf seine Zieltemperatur temperierte Temperierfluid über eine Probertemperierleitung 40 zum Probertisch 110 geleitet. Im Probertisch 110 dient das temperierte Temperierfluid zum Einstellen der gewünschten Testtemperatur des Probertisches 110. Eine Testtemperatur im negativen Grad Celsiusbereich und/oder unterhalb der Raumtemperatur kann zum Beispiel allein durch Nutzung der Kälte des Temperierfluids eingestellt werden. In einem Temperaturbereich deutlich oberhalb der Raumtemperatur kann die Testtemperatur des Probertisches 110 allein von der Heizung 120 eingestellt werden.

Zur Überprüfung der aktuellen Ist-Temperatur des Probertisches 110 kann der Temperatursensor 111 mit der Steuerung 90 verbunden sein und/oder kommunizieren. Weiterhin kann über die Steuerung 90 die Heizung 120 gesteuert und/oder geregelt werden, um so die Testtemperatur des Probertisches 110 einzustellen. In einem moderaten Temperaturbereich um die Raumtemperatur kann die Testtemperatur durch eine kontrollierte Regelung sowohl der Heizung 120 als auch der Temperierung in der Temperiervorrichtung 1 geregelt sein.

Die genannten Temperaturbereiche gelten zumindest dann, wenn das eingeleitete Temperierfluid eine Bereitstellungtemperatur um die Raumtemperatur herum aufweist. Wird das eingeleitete Temperierfluid mit einer stark abweichenden Temperatur bereitgestellt, so wird in einem Bereich um die Bereitstellungstemperatur aus einer Kombination von Kühlung und Heizung temperiert, in einem Temperaturbereich deutlich darüber alleine mit der Heizung 120, und in einem Temperaturbereich deutlich darunter alleine mit der Kälte des Temperierfluids.

Gerade beim Regeln des Probertisches 110 auf niedrige Temperaturen, also zum Beispiel beim Regeln von Testtemperaturen im negativen Grad Celsiusbereich, kann es energetisch sinnvoll sein, ein vom Probertisch 110 zurückgeführtes Temperierfluid zum Vortemperieren des frischen Temperierfluids im zweiten Wärmetauscher 20 zu verwenden. Das im Probertisch 110 zur Temperierung verwendete Temperierfluid kann über eine Rückführleitung 50 vom Probertisch 110 zurückgeführt werden in einen Rückführeingang 51 der Temperiervorrichtung 1. Vom Rückführeingang 51 kann es über eine Rückführschaltungseingangsleitung 52 in die Rückführschaltung 60 der Temperiervorrichtung 1 eingeleitet werden. Die Rückführschaltung 60 kann von der Steuerung 90 gesteuert und/oder geregelt sein. Dazu kann die Steuerung 90 ein Rückführschaltsignal bereitstellen und/oder generieren, mit dem die Rückführschaltung 60 zwischen zumindest zwei Zuständen reversibel umgeschaltet werden kann. Abhängig von der Schaltstellung der Rückführschaltung 60 befindet sich die Temperiervorrichtung 1 entweder in einem Rückführbetriebszustand oder in einem Ausströmbetriebszustand.

Im Ausströmbetriebszustand wird das zurückgeführte Temperierfluid über eine zweite Ausströmleitung 65 zu einem zweiten Ausströmausgang 62 geleitet und von dort ausströmen gelassen. Am zweiten Ausströmausgang 62 kann beispielsweise ein Schalldämpfer und/oder zumindest ein Ausströmventil angeordnet sein, um so das Temperierfluid möglichst geräuschlos und/oder gefahrlos an die Umgebung abzugeben. Im Ausströmbetriebszustand wird die Wärme bzw. Kälteenergie des zurückgeführten Temperierfluids nicht zum Vortemperieren des frisch eingeleiteten Temperierfluids genutzt.

Im Rückführbetriebszustand wird das zurückgeführte Temperierfluid von der Rückführschaltung über eine Wärmetauscherrückführleitung 63 durch den ersten Wärmetauscher 20 geleitet. Im ersten Wärmetauscher 20 kann ein Wärmeaustausch stattfinden zwischen dem zurückgeführten Temperierfluid und dem frisch durch den Fluideingang 10 eingeleiteten Temperierfluid, wobei eine Vortemperierung erfolgt. Nach Durchlaufen des ersten Wärmetauschers 20 kann das zurückgeführte Temperierfluid über eine erste Ausströmleitung 64 zu einem ersten Ausströmausgang 61 geleitet werden. Auch der erste Ausströmausgang 61 kann ähnlich wie der zweite Ausströmausgang 62 konfiguriert sein, d.h. mit einem Schalldämpfer und/oder Ausströmventil(en).

Die Temperiervorrichtung 1 kann dazu konfiguriert sein, immer dann den Rückführbetriebszustand einzunehmen, wenn der Probertisch 110 auf eine vergleichsweise tiefe Testtemperatur geregelt werden soll. Dies kann z.B. bei Testtemperaturen in einem Bereich von einer minimal regelbaren Temperatur bis zu einem Bereich um die Raumtemperatur bzw. knapp darunter gelten. Soll der Probertisch 110 beispielsweise auf eine Testtemperatur von -40°C gekühlt werden, so kann das über die Probertemperierleitung 40 zum Probertisch 110 geleitete Temperierfluid etwa auf eine Zieltemperatur von -40°C temperiert sein. Das über die Rückführleitung 50 zurückgeführte Temperierfluid kann z.B. immerhin noch eine Temperatur von etwa -30°C aufweisen, so dass es im ersten Wärmetauscher 20 gut zur Vortemperierung des in etwa bei Raumtemperatur eingeleiteten frischen Temperierfluids genutzt werden kann. Dadurch wird das frisch eingeleitete Temperierfluid im ersten Wärmetauscher 20 vorgekühlt, bevor es im zweiten Wärmetauscher 30 über die Kühlleistung der Kühlvorrichtung 35 vollständig heruntergekühlt wird auf die Zieltemperatur von -40°C.

In anderen Betriebszuständen kann die Nutzung des zurückgeführten Temperierfluids allerdings kontraproduktiv sein. Soll der Probertisch 110 beispielsweise von einer aktuellen Testtemperatur von zum Beispiel +300°C heruntergekühlt werden auf eine neue Testtemperatur im negativen Bereich und/oder nahe der Raumtemperatur, so wäre die Nutzung des sehr heißen zurückgeführten Temperierfluids im ersten Wärmetauscher 20 kontraproduktiv beim Abkühlen des Probertisches 110. Beim Abkühlen, insbesondere beim Einstellen einer Testtemperatur, welche um zumindest etwa 50K kleiner ist als die vormals benutzte Testtemperatur, kann die Temperiervorrichtung 1 in den Ausströmbetriebszustand gebracht werden. In diesem wird das zurückgeführte Temperierfluid nicht mehr durch den ersten Wärmetauscher 20 geleitet, sondern unter Umgehung des ersten Wärmetauschers 20 über den zweiten Ausströmausgang 62 ausströmen gelassen. Im Ausströmbetriebszustand kann der Probertisch 110 somit deutlich schneller und unter Aufwendung geringerer Kühlleistung abgekühlt werden auf die neu zu regelnde Testtem peratur.

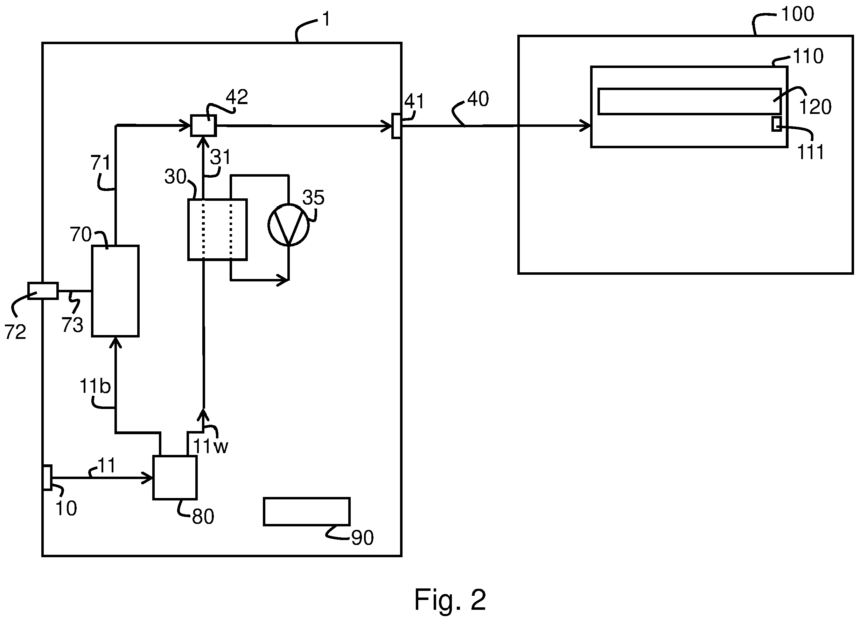

**Figur 2** zeigt eine schematische Skizze eines anderen Ausführungsbeispiels eines Probersystems mit Temperiervorrichtung 1 und Proberbehälter 100. In dem in Figur 2 gezeigten Ausführungsbeispiel sind gleiche oder ähnliche Bestandteile und/oder Merkmale mit den gleichen Bezugszeichen wie in Figur 1 gekennzeichnet.

Wie das in Figur 1 beschriebene Probersystem weist auch das in Figur 2 gezeigte Probersystem eine Temperiervorrichtung 1 und den Proberbehälter 100 mit Probertisch 110 auf. Das in Figur 2 gezeigte Probersystem weist eine Temperiervorrichtung 1 auf, in welche eine Eingangsfluidschaltung 80 integriert ist. Das frisch eingeleitete Temperierfluid wird vom Fluideingang 10 über die Eingangsleitung 11 zur Eingangsfluidschaltung 80 geleitet. Die Eingangsfluidschaltung 80 ist zwischen zumindest zwei Zuständen schaltbar. Dabei kann die Eingangsfluidschaltung 80 z.B. auf ein von der Steuerung 90 bereitgestelltes Einführschaltsignal hin entweder in einen Wärmetauschermodus oder einen Boostermodus geschaltet werden.

Ist die Eingangsfluidschaltung 80 in den Wärmetauschermodus geschaltet, so wird das eingeleitete Temperierfluid von der Eingangsfluidschaltung über eine Wärmetauschereingangsleitung 11w zum Wärmetauscher 30 geleitet. Im Wärmetauscher 30 wird das Temperierfluid temperiert, zum Beispiel von der Kühlvorrichtung 35 und im Anschluss durch eine Wärmetauscherausgangsleitung 31 und z.B. eine Zusammenführung 42 zur Probertemperierleitung 40 geleitet. Die Zusammenführung 42 kann z.B. als ein Oder/Wechselventil ausgebildet sein.

Auch wenn in Figur 2 lediglich ein einziger Wärmetauscher 30 gezeigt ist, kann das eingeleitete Temperierfluid im Wärmetauschermodus auch mehr als einen Wärmetauscher durchlaufen.

Alternativ zum Wärmetauschermodus kann die Eingangsfluidschaltung die Temperiervorrichtung 1 auch in einen Boostermodus schalten. Im Boostermodus wird das frisch eingeleitete Temperierfluid nicht durch den Wärmetauscher 30, sondern über einen Boostereingangsleitung 11b zu einem Kühlbooster 70 geleitet. Im Kühlbooster 70 wird das Temperierfluid temperiert und im Anschluss über eine Boosterausgangsleitung 71 hin zur Zusammenführung 42 und von dort zum Fluidausgang 41 und/oder zur Probertemperierleitung 40 geleitet. An der Zusammenführung 42 werden die Ausgangsleitungen 31 und 71 aus dem Wärmetauscher 30 und dem Kühlbooster 70 zusammengeführt und von dort weiter zum Fluidausgang 41 und/oder zur Probertemperierleitung 40 geleitet. Die z.B. als Oderventil ausgebildete Zusammenführung kann im Wärmetauschermodus einen unerwünschten Fluidstrom hin zum Kühlbooster 70 verhindern und im Boostermodus einen unerwünschten Fluidstrom hin zum Wärmetauscher 30.

Der Kühlbooster 70 kann auch als ein Cooling-Booster bezeichnet werden und auf dem Prinzip des Wirbelrohres beruhen. Im Wirbelrohr wird das Temperierfluid durch Verwirbelungen getrennt in einen warmen und kalten Bestandteil. Der warme Anteil des Temperierfluids kann ausströmen gelassen werden über eine Boosterausströmleitung 73 und einen Boosterausströmausgang 72. Der kalte Bestandteil des Temperierfluids kann weiterverwendet werden zum Temperieren des Probertisches 110.

Der gezeigte Kühlbooster 70 kann im Betrieb weniger Energie als die Kühlvorrichtung 35 verbrauchen. Deshalb wird, wenn es die Umstände erlauben, bevorzugt der Kühlbooster 70 zur Kühlung verwendet und nicht die Kühlvorrichtung 35 mit Wärmetauscher 30.

In einer Ausführungsform kann die Temperiervorrichtung 1 bei Temperaturen im negativen Grad Celsiusbereich im Wärmetauschermodus betrieben werden, insbesondere bis hin zu einer Temperatur knapp unterhalb der Raumtemperatur.

In einem Temperaturbereich um die Raumtemperatur kann die Temperiervorrichtung 1 im Boostermodus betrieben werden. Der Temperaturbereich um die Raumtemperatur herum kann allein mittels des Kühlboosters 70 geregelt werden. In einem Bereich deutlich oberhalb der Raumtemperatur kann der Probertisch 110 allein von der Heizung 120 temperiert werden.

Beispielsweise kann in einem Bereich von der minimal einstellbaren Testtemperatur (z.B. -40°C oder -55°C) bis zur unteren Grenztemperatur (z.B. etwa +15°C) die Temperiervorrichtung 1 normalerweise im Wärmetauschermodus betrieben werden. Bei Testtemperaturen von der unteren Grenztemperatur (z.B. etwa 15°C) bis zur oberen Grenztemperatur (z.B. etwa 60°C oder etwa 50°C) kann die Temperiervorrichtung 1 im Boostermodus betrieben werden. Bei heißeren Testtemperaturen kann die Temperiervorrichtung 1 größtenteils ausgeschaltet werden und die Temperatur des Probertisches 110 mittels der Heizung 120 eingestellt werden.

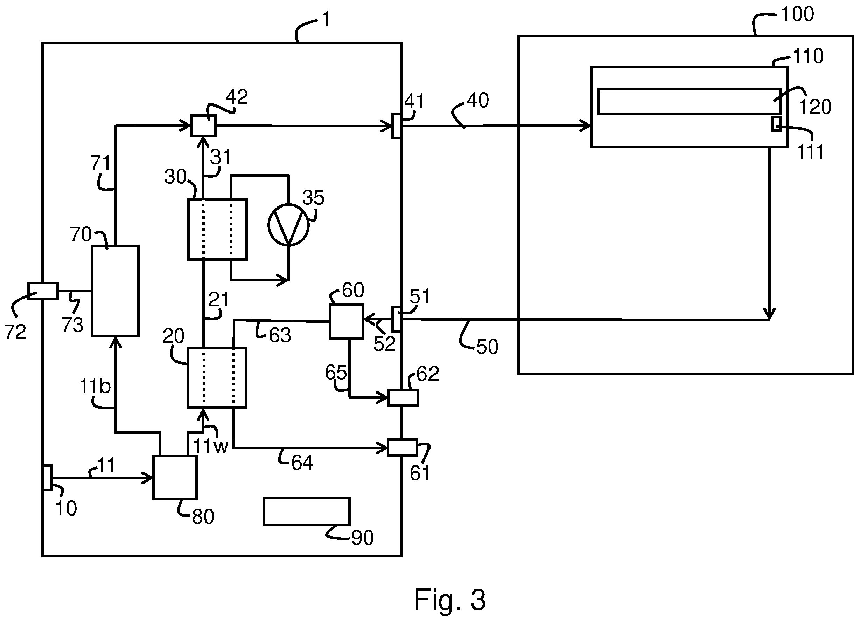

**Figur 3** zeigt eine schematische Skizze eines Probersystems mit Temperiervorrichtung 1 und Proberbehälter 100, welches die Vorteile der beiden in Figur 1 und Figur 2 gezeigten Probersysteme miteinander vereint und kombiniert. Dies kann zu einem besonders energieeffizienten und/oder geräuscharmen Betrieb der Temperiervorrichtung 1 führen, welche unterschiedliche Testtemperaturen schnell einstellen kann.

Die in Figur 3 verwendeten Bezugszeichen kennzeichnenden Merkmale, die bereits mit Bezug auf die in den Figuren 1 und 2 gezeigten Ausführungsbeispiele betrieben sind. So kann das in Figur 3 gezeigte Probersystem in unterschiedlichen Betriebszuständen betrieben werden.

Die Temperiervorrichtung 1 kann sowohl im Boostermodus als auch im Wärmetauschermodus betrieben werden. Dazu weist sie die Eingangsfluidschaltung 80 auf, die das frisch eingeleitete Temperierfluid entweder durch den Kühlbooster 70 oder den ersten Wärmetauscher 20 und den zweiten Wärmetauscher 30 zur Probertemperierleitung 40 leitet. Im Boostermodus kann die Kühlvorrichtung 35 abgeschaltet, heruntergefahren und/oder in Standby versetzt werden.

Alternativ zum Boostermodus kann die Temperiervorrichtung 1 im Wärmetauschermodus betrieben werden. Im Wärmetauschermodus kann die Temperiervorrichtung 1 entweder im Ausströmbetriebszustand oder im Rückführbetriebszustand betrieben werden. Diese Betriebszustände werden über die Steuerung 90 und die Rückführschaltung 60 gesteuert und/oder geregelt. Leitet die Rückführschaltung 60 das zurückgeführte Temperierfluid durch den ersten Wärmetauscher 20, so kann es dort zur Vortemperierung des frischen eingeleiteten Temperierfluids verwendet werden. Leitet die Rückführschaltung 60 das zurückgeführte Temperierfluid um den ersten Wärmetauscher 20 herum, so durchströmt das frisch eingeleitete Temperierfluid den ersten Wärmetauscher 20 im Wesentlichen ohne Temperaturänderung und wird ausschließlich im zweiten Wärmetauscher 30 temperiert.

In einem Heizbetriebszustand kann sowohl die Kühlvorrichtung 35 als auch der Kühlbooster 70 ausgeschaltet bzw. in Standby versetzt werden.

Durch die unterschiedlichen Betriebszustände und Betriebsmodi ist die in Figur 3 gezeigte Ausführungsform besonders energieeffizient, sparsam und reduziert die Betriebsgeräusche.

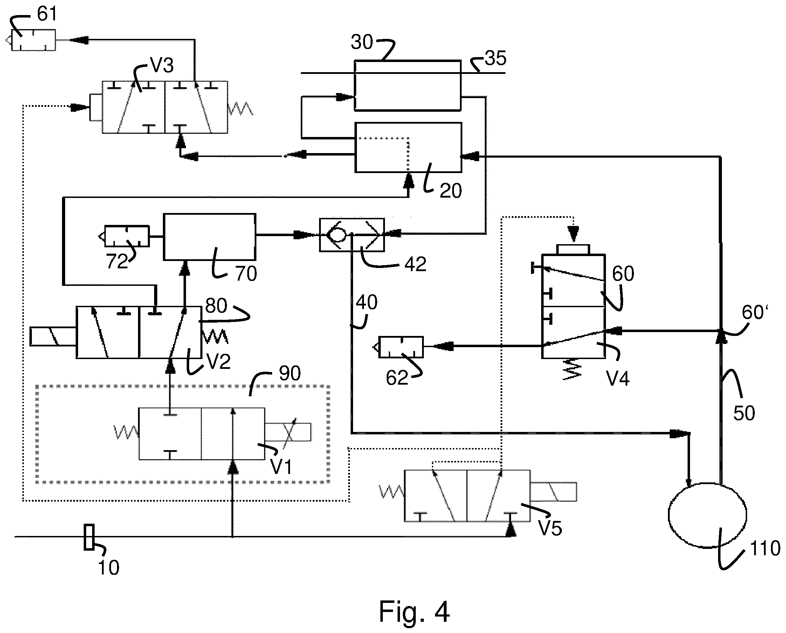

**Figur 4** zeigt einen schematischen Schaltplan eines Ausführungsbeispiels eines Probersystems mit einer Temperiervorrichtung, von der in Figur 4 zumindest Bestandteile gezeigt sind, und einem Probertisch 110. Figur 4 zeigt ein Ausführungsbeispiel, welches dem in Figur 3 gezeigten ähnelt, aber in einem anderen Detailgrad.

Wie in dem in Figur 3 gezeigten Ausführungsbeispiel kann das Probersystem einen Fluideingang 10 aufweisen, durch den frisch eingeleitetes Temperierfluid eingeleitet werden kann. Das frisch eingeleitete Temperierfluid wird durch die Steuerung 90 mit einem Proportionalventil V1 geleitet. Alternativ kann das frisch eingeleitete Temperierfluid auch durch ein Schaltventil V5 geleitet werden, welches als ein Ablass- und/oder Schalldämpferventil ausgebildet sein kann. Im Proportionalventil V1 kann eingestellt werden, wieviel Temperierfluid zur Temperierung verwendet werden soll.

Abhängig vom Betriebszustand und der Schaltstellungen des Proportionalventils V1 und/oder des Schaltventils V5 kann ein Bestandteil des frisch zugeleiteten Temperierfluids auch unter Umgehung der Wärmetauscher 20, 30 und des Kühlboosters 70 unmittelbar ausströmen gelassen werden, entweder über ein Schalldämpferventil V3 und den ersten Ausströmausgang 61 und/oder über ein Ablassventil V4 und den zweiten Ausströmausgang 62.

Vom Proportionalventil V1 wird das Temperierfluid durch ein Schaltventil V2 geleitet, welches als Bestandteil der Eingangsfluidschaltung 80 ausgebildet sein kann. Abhängig von der Schaltstellung der Eingangsfluidschaltung 80 befindet sich die Temperiervorrichtung 1 entweder im Boostermodus oder im Wärmetauschermodus.

### Boostermodus, z.B. im moderaten Temperaturbereich

Im Boostermodus wird das Temperierfluid von dem Schaltventil V2 durch den Kühlbooster 70 geleitet und dort temperiert. Von dort wird der warme Anteil des Temperierfluids über den Boosterausströmausgang 72 ausgeleitet, während der kalte Anteil über eine Zusammenführung 42 in die Probertemperierleitung 40 geleitet wird. Die Zusammenführung 42 kann ein Wechselventil und/oder ein Oderventil aufweisen.

Im Boostermodus wird das eingeleitete Temperierfluid über den Kühlbooster 70 zum Probertisch 110 geleitet. Der Boostermodus kann beispielsweise dann genutzt werden, wenn der Probertisch 110 auf eine Testtemperatur in einem moderaten Temperaturbereich konditioniert werden soll, beispielsweise ein Temperaturbereich von einer unteren Grenztemperatur bis zu einer oberen Grenztemperatur. Dieser moderate Temperaturbereich kann dabei die Raumtemperatur und/oder die Bereitstellungtemperatur umfassen, in der das frisch eingeleitete Temperierfluid bereitgestellt wird. In einem Ausführungsbeispiel beträgt die untere Grenztemperatur etwa 10°C bis etwa 25°C, z.B. etwa 15°C. In einem Ausführungsbeispiel beträgt die obere Grenztemperatur etwa 40°C bis etwa 80°C, bevorzugt etwa 50°C bis etwa 70°C, besonders bevorzugt etwa 60°C.

Im Boostermodus ist das Proportionalventil V1 geöffnet, so dass das frisches Temperierfluid durch das Proportionalventil V1 strömen kann. Weiterhin ist das Schaltventil V2 derart geöffnet, dass das Temperierfluid hin zum Kühlbooster 70 geleitet wird. Auch das Schaltventil V5 ist geöffnet, um so überschüssiges Temperierfluid ableiten zu können. Das Ablassventil V4 kann geschlossen sein und das Schalldämpferventil V3 geöffnet, so dass das zurückgeführte Temperierfluid durch den ersten Wärmetauscher 20 und das Schalldämpferventil V3 ausströmen kann (Rückführbetriebszustand), ohne das frisch eingeleitete Temperierfluid vorzutemperieren, da dieses den ersten Wärmetauscher 20 im Boostermodus gar nicht passiert. Alternativ kann das Ablassventil V4 geöffnet sein (Ausströmbetriebszustand), um so das zurückgeführte Temperierfluid durch das Ablassventil V4 und den zweiten Ausströmausgang 62 ausströmen zu lassen. Im Boostermodus kann die Kühlvorrichtung 35 abgeschaltet und/oder im Standby betrieben werden.

### Wärmetauschermodus

Im Wärmetauschermodus wird das eingeleitete Temperierfluid vom Schaltventil V2 in den ersten Wärmetauscher 20 und von dort in den zweiten Wärmetauscher 30 geleitet. Im zweiten Wärmetauscher 30 wird das Temperierfluid von der Kühlvorrichtung 35 als eine Kältestufe temperiert und anschließend zur Zusammenführung 42 geleitet. Von dort wird es weiter durch die Probertemperierleitung 40 zum Probertisch 110 geleitet.

Vom Probertisch 110 wird das dort bereits zur Temperierung benutzte Temperierfluid in die Rückführleitung 50 eingebracht und zurück zur Temperiervorrichtung geführt.

Dabei passiert das zurückgeführte Temperierfluid eine Gabelung 60', welche als Bestandteil der Rückführschaltung 60 ausgebildet sein kann. Die Rückführschaltung 60 weist ein Ablassventil V4 auf, über das das zurückgeführte Temperierfluid unter Umgehung des ersten Wärmetauschers im zweiten Ausströmausgang 62 ausströmen gelassen werden kann. Abhängig von der Schaltstellung des Ablassventils V4 ist die Temperiervorrichtung entweder im Ausströmbetriebszustand oder im Rückführbetriebszustand.

### Rückführbetriebszustand, z.B. in einem niedrigen Temperaturbereich

Im Wärmetauschermodus und Rückführbetriebszustand ist die Eingangsfluidschaltung 80 auf den Wärmetauschermodus geschaltet und die Rückführschaltung 60 auf den Rückführbetriebszustand. Ein derartiges Betreiben der Temperiervorrichtung kann insbesondere dann sinnvoll verwendet werden, wenn eine deutliche Kühlung des Probertisches 110 benötigt wird. Dies kann dann der Fall sein, wenn eine Testtemperatur z.B. in einem niedrigen Temperaturbereich geregelt werden soll, also z.B. eine Testtemperatur von der minimal einstellbaren Temperatur, z.B. -40°C oder -60°C, bis hin zur voranstehend beschriebenen unteren Grenztemperatur des moderaten Temperaturbereichs.

Im Wärmetauschermodus und Rückführbetriebszustand ist das Proportionalventil V1 sowie das Schaltventil V2 geöffnet. Weiterhin ist auch das Schaltventil V5 geöffnet und das Ablassventil V4 geschlossen. Dies zwingt das zurückgeführte Temperierfluid durch den ersten Wärmetauscher 20, wonach es durch ein geöffnetes Schalldämpferventil V3 zum ersten Ausströmausgang 61 strömen kann. Dabei wird das zurückgeführte Temperierfluid in den ersten Wärmetauscher 20 geleitet, wo es das frisch eingeleitete Temperierfluid vortemperieren kann, um so dessen Kühlinhalt nicht zu verschwenden, sondern weiter zu nutzen.

### Ausströmbetriebszustand, z.B. beim Abkühlen des Probertisches

In einem Wärmetauschermodus und Ausströmbetriebszustand kann die Temperiervorrichtung dazu verwendet werden, den Probertisch 110 von einer hohen Temperatur abzukühlen. Diese Kombination der Betriebsmodi und -zustände ist beispielsweise dann sinnvoll, wenn der Probertisch von einer hohen ersten Temperatur (zum Beispiel einer Temperatur im Bereich von etwa 100°C bis 400°C) abgekühlt werden soll auf eine deutlich niedrigere zweite Temperatur, beispielsweise eine zweite Temperatur, die zumindest um 50K niedriger ist als die erste, insbesondere um zumindest 100K niedriger. Die zweite Temperatur kann z.B. im Bereich von der minimal einstellbaren Temperatur bis zur oberen Grenztemperatur sein.

Dabei ist die Eingangsfluidschaltung 80 auf den Wärmetauschermodus geschaltet und die Rückführschaltung 60 auf den Ausströmbetriebszustand. Dies kann dadurch realisiert werden, dass das Proportionalventil V1 geöffnet und das Schaltventil V2 derart geöffnet ist, ohne das eingeleitete Temperierfluid zum ersten Wärmetauscher 20 geleitet wird. Das Schaltventil V5 ist geschlossen und das Ablassventil V4 geöffnet, während das Schalldämpferventil V3 geschlossen ist. Die geschlossene Stellung des Schalldämpferventils V3 verursacht einen Rückstau, so dass das über die Rückführleitung 50 zurückgeführte Temperierfluid nicht mehr durch den ersten Wärmetauscher 20 geleitet werden kann. Es strömt vielmehr durch das Ablassventil V4 über den zweiten Ausströmausgang 62 aus. So kann das frisch eingeleitete Temperierfluid allein im zweiten Wärmetauscher 30 temperiert und heruntergekühlt werden, ohne dass das heiße, zurückgeführte Temperierfluid im ersten Wärmetauscher 20 eine ineffiziente und ungünstige Vortemperierung bewirkt.

### Heizbetriebszustand

In einem Heizbetriebszustand können sowohl der Kühlbooster 70 als auch die Kältevorrichtung 35 abgeschaltet oder im Standby sein, und die Temperatur des Probertisches 110 lediglich durch eine (nicht in Figur 4 gezeigte) Heizung 120 konditioniert werden. Der Heizbetrieb kann insbesondere in einem Temperaturbereich oberhalb der oberen Grenztemperatur verwendet werden, also zum Beispiel von einem Temperaturbereich von der oberen Grenztemperatur bis zur maximal einstellbaren Temperatur des Probertisches 110.

In einer alternativen, nicht in den Figuren gezeigten Ausführungsform ist die Eingangsschaltung 80 zwischen dem ersten Wärmetauscher 20 und dem zweiten Wärmetauscher 30 angeordnet. Somit kann die Rückführung und das Vortemperieren mittels des zurückgeführten Temperierfluids sowohl im Wärmetauschermodus als auch im Boostermodus genutzt werden. Der übrige Aufbau dieser Temperiervorrichtung und/oder dieses Probersystems kann dabei analog zu den in den Figuren 3 und/oder 4 gezeigten Ausführungsformen ausgebildet sein.

Durch das Probersystem und/oder die Temperiervorrichtung wird eine besonders effiziente Energienutzung ermöglicht sowie ein schnelles Wechseln und Einstellen einer geänderten Testtemperatur des Probertisches 110. Weiterhin können Betriebsgeräusche reduziert werden.

### Bezugszeichenliste

- 1: Temperiervorrichtung
- 10: Fluideingang
- 11: Eingangsleitung
- 11b: Boostereingangsleitung
- 11w: Wärmetauschereingangsleitung
- 20: erster Wärmetauscher
- 21: Wärmetauscherverbindungsleitung
- 30: zweiter Wärmetauscher
- 31: Wärmetauscherausgangsleitung
- 35: Kühlvorrichtung
- 40: Probertemperierleitung
- 41: Fluidausgang
- 42: Zusammenführung
- 50: Rückführleitung
- 51: Rückführeingang
- 52: Rückführschaltungseingangsleitung
- 60: Rückführschaltung
- 60': Gabelung
- 61: erster Ausströmausgang
- 62: zweiter Ausströmausgang
- 63: Wärmetauscherrückführleitung
- 64: erste Ausströmleitung
- 65: zweite Ausströmleitung
- 70: Kühlbooster
- 71: Boosterausgangsleitung
- 72: Boosterausströmausgang
- 73: Boosterausströmleitung
- 80: Eingangsfluidschaltung
- 90: Steuerung
- 100: Proberbehälter
- 110: Probertisch
- 111: Temperatursensor
- 120: Heizung

- V1: Proportionalventil
- V2: Schaltventil
- V3: Schalldämperventil
- V4: Ablassventil
- V5: Schaltventil

## Patentansprüche

1. Temperiervorrichtung (1) zum Temperieren eines Probertisches (110) für Halbleiterwafer und/oder Hybride mit
- einem Fluideingang (10) zum Einleiten eines Temperierfluids in die Temperiervorrichtung (1);
- zumindest einem Wärmetauscher (20; 30) zum Temperieren des Temperierfluids;
- einem Kühlbooster (70) zum Temperieren des Temperierfluids;
- einer Probertemperierleitung (40), durch welche das temperierte Temperierfluid zum Probertisch (110) leitbar ist; und
- eine Eingangsfluidschaltung (80), welche das eingeleitete Temperierfluid auf ein Einführschaltsignal hin wahlweise entweder durch den zumindest einen Wärmetauscher (20; 30) oder durch den Kühlbooster (70) in die Probertemperierleitung (40) leitet.

2. Temperiervorrichtung (1) nach Anspruch 1, wobei die Eingangsfluidschaltung (80) in einem Wärmetauschermodus der Temperiervorrichtung (1) das eingeleitete Temperierfluid durch den zumindest einen Wärmetauscher (20; 30) in die Probertemperierleitung (40) leitet, wenn der Probertisch (110) von einem aufgeheizten Zustand abgekühlt wird.

3. Temperiervorrichtung (1) nach Anspruch 1 oder 2, wobei die Eingangsfluidschaltung (80) in einem Wärmetauschermodus der Temperiervorrichtung (1) das eingeleitete Temperierfluid durch den zumindest einen Wärmetauscher (20; 30) in die Probertemperierleitung (40) leitet, wenn der Probertisch (110) auf eine Temperatur unterhalb einer unteren Grenztemperatur, welche im Bereich von etwa 10°C bis etwa 25°C liegt, temperiert wird.

4. Temperiervorrichtung (1) nach einem der vorangegangenen Ansprüche, wobei die Eingangsfluidschaltung (80) in einem Boostermodus der Temperiervorrichtung (1) das eingeleitete Temperierfluid durch den Kühlbooster (70) in die Probertemperierleitung (40) leitet, wenn der Probertisch (110) auf eine Temperatur oberhalb einer unteren Grenztemperatur, welche im Bereich von etwa 10°C bis etwa 25°C liegt, und unterhalb einer oberen Grenztemperatur, welche im Bereich von etwa 40°C bis etwa 70°C liegt, temperiert wird.

5. Temperiervorrichtung (1) nach einem der vorangegangenen Ansprüche, wobei der Kühlbooster (70) ein Wirbelrohr aufweist, in dem das eingeleitete Temperierfluid in einen warmen und einen kalten Stromanteil aufgeteilt wird, von welchem nur der kalte Stromanteil in die Probertemperierleitung (40) geleitet wird.

6. Temperiervorrichtung (1) nach einem der vorangegangenen Ansprüche, wobei die Eingangsfluidschaltung (80) ein Schaltventil aufweist, durch welches das eingeleitete Temperierfluid in Abhängigkeit von der Schaltstellung des Schaltventils wahlweise entweder zu dem zumindest einen Wärmetauscher (20; 30) oder zu dem Kühlbooster (70) geleitet wird.

7. Temperiervorrichtung (1) nach einem der vorangegangenen Ansprüche mit
- einem ersten Wärmetauscher (20) zum Vortemperieren des eingeleiteten Temperierfluids;
- einem zweiten Wärmetauscher (30) zum Temperieren des Temperierfluids; und
- eine Rückführschaltung (60), welche ein vom Probertisch (110) zurückgeführtes Temperierfluid auf ein Rückführschaltsignal hin wahlweise entweder durch den ersten Wärmetauscher (20) leitet oder unter Umgehung des ersten Wärmetauschers (20) ausströmen lässt.

8. Temperiervorrichtung (1) nach Anspruch 7, wobei das zurückgeführte Temperierfluid in einem Rückführbetriebszustand der Temperiervorrichtung (1) das eingeleitete Temperierfluid in dem ersten Wärmetauscher (20) vortemperiert, wenn es von der Rückführschaltung (60) durch den ersten Wärmetauscher (20) geleitet wird;
und/oder
wobei das zurückgeführte Temperierfluid nach Durchströmen des ersten Wärmetauschers (20) über einen Ausströmausgang (61) ausströmen gelassen wird.

9. Temperiervorrichtung (1) nach Anspruch 7 oder 8, wobei die Rückführschaltung (60) in einem Ausströmbetriebszustand der Temperiervorrichtung (1) das vom Probertisch (110) zurückgeführte Temperierfluid unter Umgehung des ersten Wärmetauschers (20) ausströmen lässt, wenn der Probertisch (110) von einem aufgeheizten Zustand abgekühlt wird;
und/oder
wobei die Rückführschaltung (60) beim Abkühlen des Probertisches (110) in einem Ausströmbetriebszustand der Temperiervorrichtung (1) das vom Probertisch (110) zurückgeführte Temperierfluid solange unter Umgehung des ersten Wärmetauschers (20) ausströmen lässt, bis eine Temperatur des Probertisches unter eine Probertischgrenztemperatur aus einem Bereich von etwa 20°C bis etwa 40°C fällt.

10. Temperiervorrichtung (1) nach einem der Ansprüche 7 bis 9, wobei die Rückführschaltung (60) in einem Rückführbetriebszustand der Temperiervorrichtung (1) das vom Probertisch (110) zurückgeführte Temperierfluid durch den ersten Wärmetauscher (20) leitet, wenn der Probertisch auf eine Temperatur unterhalb einer Rückführgrenztemperatur temperiert wird.

11. System mit einem Probertisch (110) und einer daran zumindest über seine Probertemperierleitung (40) angeschlossene Temperiervorrichtung (1) nach einem der vorangegangenen Ansprüche.

12. Verfahren zum Temperieren eines Probertisches (110) für Halbleiterwafer und/oder Hybride, mit den Schritten:
- Einleiten eines Temperierfluids in zumindest einen Wärmetauscher (20; 30) zum Temperieren des Temperierfluids;
- Einleiten des Temperierfluids in einen Kühlbooster (70) zum Temperieren des Temperierfluids;
- Leiten des temperierten Temperierfluids zum Probertisch (110); und
- Bereitstellen eines Einführschaltsignals zum Ansteuern und/oder Regeln einer Eingangsfluidschaltung (80), wobei das eingeleitete Temperierfluid auf das Einführschaltsignal hin wahlweise entweder durch den zumindest einen Wärmetauscher (20; 30) oder durch den Kühlbooster (70) zum Probertisch geleitet wird.

13. Verfahren nach Anspruch 12, mit zumindest einem der folgenden Schritte:
- Leiten des eingeleiteten Temperierfluids durch den zumindest einen Wärmetauscher (20; 30) zum Probertisch (110), wenn der Probertisch (110) auf eine Temperatur unterhalb einer unteren Grenztemperatur, welche im Bereich von etwa 10°C bis etwa 25°C liegt, temperiert wird;
- Leiten des eingeleiteten Temperierfluids durch den Kühlbooster (70) zum Probertisch (110), wenn der Probertisch (110) auf eine Temperatur oberhalb einer unteren Grenztemperatur, welche im Bereich von etwa 10°C bis etwa 25°C liegt, und unterhalb der oberen Grenztemperatur, welche im Bereich von etwa 40°C bis etwa 70°C liegt, temperiert wird;
- Abschalten einer im Wärmetauscher (20; 30) zur Temperierung genutzten Kühlvorrichtung (35), wenn das eingeleitete Temperierfluids durch den Kühlbooster (70) zum Probertisch (110) geleitet wird; und/oder
- Abschalten einer im Wärmetauscher (20; 30) zur Temperierung genutzten Kühlvorrichtung (35), und/oder des Kühlboosters (70), wenn der Probertisch (110) auf eine Temperatur oberhalb der oberen Grenztemperatur, welche im Bereich von etwa 40°C bis etwa 70°C liegt, temperiert wird.

14. Verfahren nach einem der Ansprüche 12 oder 13 mit den Schritten:
- Einleiten des Temperierfluids in einen ersten Wärmetauscher (20) zum Vortemperieren des eingeleiteten Temperierfluids;
- Leiten des Temperierfluids vom ersten Wärmetauscher (20) in einen zweiten Wärmetauscher (30) zum Temperieren des Temperierfluids; und
- Bereitstellen eines Rückführschaltsignals zum Ansteuern und/oder Regeln einer Rückführschaltung (60), wobei ein vom Probertisch (110) zurückgeführtes Temperierfluid auf das Rückführschaltsignal hin wahlweise entweder durch den ersten Wärmetauscher (20) geleitet wird oder unter Umgehung des ersten Wärmetauschers (20) ausströmen gelassen wird.

15. Verfahren nach Anspruch 14, mit zumindest einem der folgenden Schritte:
- Ausströmen lassen des vom Probertisch (110) zurückgeführten Temperierfluids unter Umgehung des ersten Wärmetauschers (20), wenn der Probertisch (110) von einem aufgeheizten Zustand abgekühlt wird; und/oder
- Leiten des vom Probertisch (110) zurückgeführten Temperierfluids durch den ersten Wärmetauscher (20), wenn der Probertisch (110) auf eine Temperatur unterhalb einer Rückführgrenztemperatur temperiert wird.
